# EUROPÄISCHE PATENTANMELDUNG

(11) **EP 2 403 070 A1**
(43) Veröffentlichungstag der Anmeldung: **04.01.2012**
(21) Anmeldenummer: 11002806.5
(22) Anmeldetag: 05.04.2011
(51) Int. Cl.: H01R 13/24

(54) **Federkontakt**

(30) Priorität: 03.07.2010 DE 102010026027
(71) Anmelder: Amphenol-Tuchel Electronics GmbH, 74080 Heilbronn (DE)
(72) Erfinder: Braun, Gerhard, 74626 Bretzfeld-Bitzfeld (DE); Kaiser, Olga, 74080 Heilbronn (DE)

(57) **Zusammenfassung**

Die Erfindung betrifft einen Federkontakt zur Leiterplattenkontaktierung umfassend einen Anschlussabschnitt sowie einen Kontaktabschnitt zur Kontaktierung mit einem Gegenkontakt, wobei zwischen dem Anschlussabschnitt und dem Kontaktabschnitt ein Kontaktfederabschnitt aus einer Kontaktzunge ausgebildet ist und die Kontaktzunge über eine Kontaktzungenbreite B verfügt, die durch den Abstand zwischen der Unterkante und der Oberkante der Kontaktzunge definiert ist, wobei die Kontaktzunge als eine helixförmige archimedische Spirale mit einer Ganghöhe h ausgebildet ist.

## Beschreibung

Die Erfindung betrifft einen Federkontakt für die Leiterptattenkontaktierung.

Die Erfindung betrifft insbesondere einen Federkontakt zur Leiterplattenkontaktierung für Miniaturanwendungen.

### Stand der Technik

Üblicherweise werden Kontaktfedern aus einem Blech ausgestanzt, vorzugsweise aus einem Federblechmaterial, wobei der Kontakt Ober einen Anschlussabschnitt und einen Federschenkel verfügt.

Beispielsweise werden U-förmige Federkontakte ausgestanzt, wobei die beiden U-Schenkel, welche Federschenkel bilden, bezüglich des U-Steges so zueinander verdreht werden, wodurch die U-Schenkel sich gegenüber liegen und die Aufnahme für ein Kontaktmesser bilden.

Alternative Ausführungsformen finden sich insbesondere im Bereich von Mobilfunkanwendungen und Kartenlesern, bei denen so genannte Kartenkontakte als Kontakte mit einem Kontaktanschlussende und einem Kontaktarm und einem im wesentlichen löffelförmig gebogenen Kontaktende verwendet werden. Dabei bestimmt sich der Federweg solcher Kontakte durch den Anstellwinkel des Federarms zum Anschlussende sowie der Federarmlänge.

Insbesondere bei Miniatursteckverbindern und Miniaturanwendungen und allgemein beim Mangel ausreichenden Bauraums sind die im Stand der Technik bekannten Kontakte in ihrer Federweglänge unzureichend ausgebildet.

So beschäftigt sich z. B. die DE 10 2005 010 704 A1 mit einer Federbuchse für einen Miniatursteckverbinder mit mindestens einer Gehäusekammer in einem Buchsengehäuse für die Aufnahme einer einteiligen Kontaktfeder, deren kontaktgebende Federzungen überdeckungsfrei aus einem ebenen Blechstanzteil mindestens einseitig ausgebogen sind, wobei das eine Ende des Blechstanzteils, ein die Federzungen tragender Quersteg, einen Festanschluss ausbildet und das andere, freie Ende den Aufnahmebereich für ein Kontaktmesser.

In der DE 87 10 419 U1 sowie in der DE 197 24 581 sind weitere aus einem Blechstanzteil gebildete Kontaktelemente beschrieben.

Diese Federelemente haben relativ lange Federschenkel, so dass diese nicht die Erfordernisse für einen geringen Bauraum erfüllen.

Die Kontaktanpresskraft bestimmt sich bei einem Federkontakt unmittelbar durch die Federweglänge, Im einfachsten Fall würde der Fachmann die Federweglänge verkürzen, um einen gegebenen Kontakt auf eine kleinere Applikation anzuwenden. Dies führt in der Konsequenz aber dazu, dass die Federkraft abnimmt und unzureichende Kontaktierung mit einem Gegenkontakt auftritt. Insbesondere bei Kontakten die als Anpresskontakte ausgebildet sind, werden dadurch unzureichende elektrische Verbindungen geschaffen, die entweder eine zu geringe Stromtragfähigkeit aufweisen oder im Betrieb zu Unterbrechungen führen.

Es ist daher Aufgabe der vorliegenden Erfindung, ein Federkontakt bereitzustellen, der vorbesagte Nachteile überwinder und trotz eines geringen Bauraumbedarfs, über einen ausreichende Federweg und damit über ausreichende Federkräfte verfügt.

Diese Aufgabe wird gelöst mit einem Federkontakt gemäß Anspruch 1.

Weitere Ausgestaltungen der Erfindung ergeben sich anhand der Ausführungsbeispiele, der Beschreibung und den Figuren.

Die Aufgabe der vorliegenden Erfindung wird dadurch gelöst, dass ein Federkontakt mit einem Federkontaktabschnitt bereitgestellt wird, der als helixförmige, archimedische Spirale ausgebildet ist und mit Vorteil aus einem Blech als Stanz-Biegeteil hergestellt wurde.

Der erfindungsgemäße Federkontakt verfügt über einen Anschlussabschnitt und einen Kontaktabschnitt zum Verbinden mit einem Gegenkontakt. Zwischen dem Anschlussabschnitt des Federkontaktes und dem Kontaktabschnitt befindet sich ein Kontaktfederabschnitt aus einem im wesentlichen spiralförmig gebogenen Federblattes. Das Federblatt hat vorzugsweise eine Federblattbreite B und ist entlang seiner Spiralachse helixförmig ausgebildet. Im folgenden werden dabei zur Klarheit folgende Begriffe verwendet.

Im Sinne der vorliegenden Erfindung wird unter einer archimedischen Spirale, die dem Fachmann geläufige Spirale, bezeichnet, die z. B. beim Aufwickeln eines gleichmäßig dicken Teppichs entsteht. Dabei liegt jedenfalls die Innenseite einer Spiralwendel an der Außenseite der benachbarten Spiralwendel an. Als helix-oder helixförmig wird die in Fachkreisen bekannte Helixform betrachtet. Hierbei handelt es sich um eine Kurve, die sich mit konstanter Steigung um den Mantel eines Zylinders windet. Je nach Windungsrichtung bezeichnet man die Helix als rechtsgängig oder linksgängig. Wobei linksgängig eine Windung gegen den Uhrzeigersinn bezeichnet. Eine Helix wird mathematisch auch als Schraubenlinie im karthesischen Koordinatensystem wie folgt beschrieben. X(t) = (r·cos(2·π·t), r·sin(2·π·t), h·t+c). Hierbei bezeichnet h die Ganghöhe, also diejenige Strecke, um die sich die Schraube bei einer vollen Umdrehung in Richtung der Zylinderachse (Z-Richtung) windet. r bezeichnet den Radius und c die Verschiebung der Schraube in Z-Richtung. Die Steigung der Helix selbst wird definiert als K, wobei K=h/2πr beschrieben wird. Der Gangwinkel α der Helix wird errechnet aus dem Arcustangenz von K, der im folgenden mit α bezeichnet wird.

Durch Verwendung eines erfindungsgemäßen Federblattes, welches als archimedische Spirale einerseits zusammengewickelt und um die Z-Achse helixförmig um die Ganghöhe h verschoben ist, entsteht ein Federelement, dass abhängig von der Anzahl der Spiralwendel, somit der Anzahl der Umdrehungen der Spirale entsprechend langen Federweg ergibt. Vorzugsweise ist die Ganghöhe h der erfindungsgemäßen helixförmigen, archimedischen Spirale geringer ausgebildet als die Breite der Kontaktzunge einer jeden Spiralwendel. Hierdurch wird eine Überdeckung einer jeden Spiralwendel zur benachbarten Spiralwendel erzielt. Dies hat technisch den Vorteil, dass beim Zusammendrücken des Federkontaktes in Achsrichtung (Z-Richtung) eine Kollision der Unterkante einer Spiralwendel zu der benachbarten Oberkante der darunter liegenden Spiralwendel verhindert wird. Dies sollte bereits durch die archimedische Form der Spirale gewährleistet sein. Allerdings kann es im Rahmen von Fertigungstoleranzen dazu kommen, dass nicht eine ideale archimedische Spirale erzeugt wird, so dass bei einem Versatz einer Spiralwendel zur benachbarten Spiralwendel und diese beim Zusammendrücken des Federkontaktes mit der benachbarten Spiralwendel kollidiert.

In einer alternativen Ausführungsform kann die Breite der Kontaktzunge bei jeder Spiralwendel unterschiedlich ausgeführt sein, so dass beispielsweise bei Ausführung des Federkontaktes mit drei Spiralwendeln, die untere Spiralwendel eine Breite B₁, die mittlere Spiralwendel eine Breite B₂, geringer als B₁ und die obere Spiralwendel eine Breite B₃, geringer als B₂ aufweisen könnte. Hierdurch lassen sich unterschiedlich skalierbare Federkontaktelemente ausbilden, die über entsprechend unterschiedliche Federeigenschaften verfügen. Der Federweg eines solchen Kontaktes lässt sich insgesamt dadurch einstellen, dass die Ganghöhe h der helixförmigen archimedischen Spirale auf die Anwendung angepasst wird und gleichzeitig die Breite B der Kontaktzunge entsprechend ausgeführt sein kann. Der Winkel, um den sich die Spirale in einer xy-Ebene, somit senkrecht zu Z-Achse und damit um die Z-Achse dreht, wird Im folgenden als Polarwinkel ϕ bezeichnet. Eine vollständige Umdrehung entspricht damit dem Polarwinkel von 360°.

Mit Vorteil kann die erfindungsgemäße Ausgestaltung des Federkontaktes unmittelbar an einem in Fachkreisen so benannten Pilotstreifen zur Industriellen Montage angebracht, ausgestanzt und gebogen werden.

Mit Vorteil ist die unterste Spiralwendel an ihrer Unterkante mittels eines Stützelementes abgestützt, so dass bei Betätigung des Federkontaktes ein unsymmetrisches Abknicken oder Verbiegen des Federkontaktes verhindert wird.

Anhand der folgenden Ausführungsbeispiele soll die Erfindung und weitere Vorteile näher erläutert werden. In die zugehörigen schematischen ausführenden Zeichnungen zeigen hierzu:
Fig. 1 eine Seitenansicht eines erfindungsgemäßen Federkontaktes;
Fig. 2 eine Draufsicht auf den Federkontakt gemäß Fig. 1;
Fig. 3 eine perspektivische Ansicht des Federkontaktes gemäß Fig. 1;
Fig. 4 ein erfindungsgemäßer Federkontakt an einem Pilotstreifen.

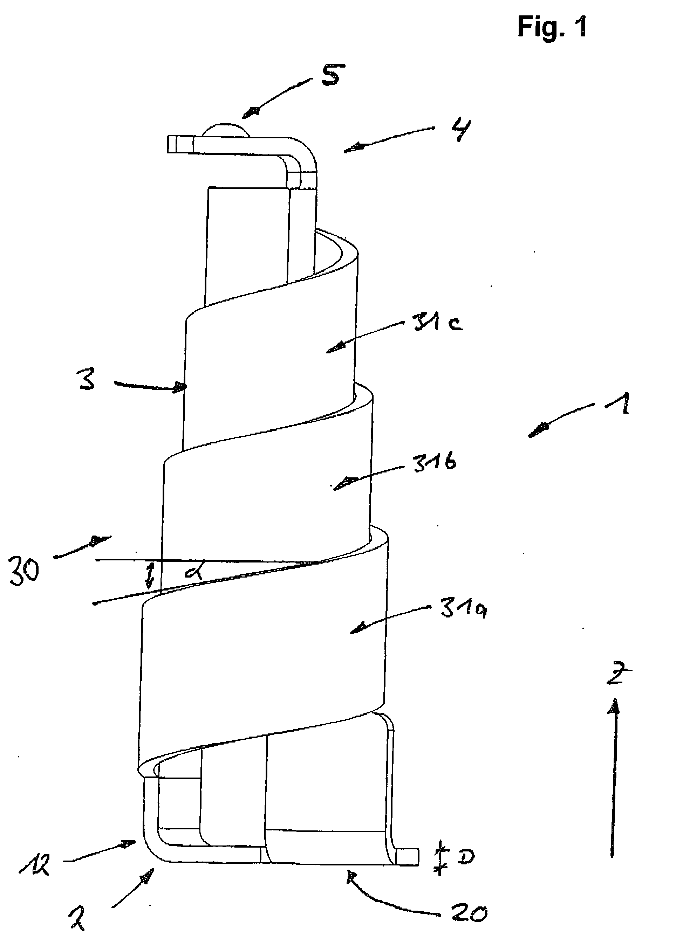

Die Fig. 1 zeigt beispielhaft einen Federkontakt 1, der über einen Anschlussabschnitt 2 in seinem in der Fig. 1 unteren Ende aufweist, sowie einen Kontaktabschnitt 4. Der Federkontakt 1 ist vorzugsweise aus einem Blech gebildet durch Stanz-Biegeprozesse.

Im vorliegenden Fall weist daher der Federkontakt 1 eine im wesentliche gleiche Blechstärke der Dicke D auf. Zwischen dem Anschlussabschnitt 2 und dem Kontaktabschnitt 4 befindet sich ein Kontaktfederabschnitt 30. Der Federabschnitt 30 ist mit dem Anschlussabschnitt 2 über einen Verbindungsabschnitt 12 mit diesem verbunden. Im Verbindungsabschnitt 12 erfährt der Federkontakt eine Krümmung im Winkel von ca. 90°. Unmittelbar an den Verbindungsabschnitt 12 schließt sich eine als helixförmig aufgewickelte, in Form einer archimedischen Spirale, ausgeformte Kontaktzunge 3 an, die im folgenden als helixförmige archimedische Spirale bezeichnet wird, deren Spiralachse sich in Z-Richtung erstreckt. Um die Spiralachse sind mehrere Spiralwendel 31a, 31b, 31c angeordnet.

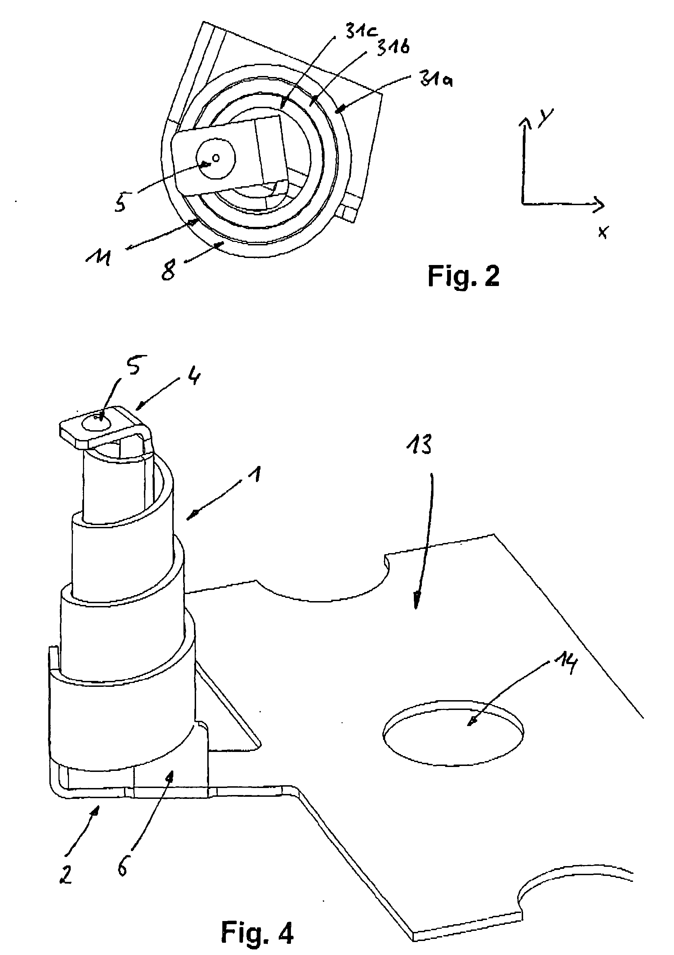

Wie in Fig. 1 und Fig. 2 ersichtlich, sind vorzugsweise drei Spiralwendeln vorgesehen. Eine Spiralwendel zeichnet sich dadurch aus, dass die Kontaktzunge 3 eine vollständige Umdrehung um den Polarwinkel ϕ 380° vollzieht. Die Spiralwendeln 31 a, 31 b, 31 c sind in Z-Richtung helixförmig angeordnet, sozusagen durch eine Ganghöhe h gegeneinander versetzt angeordnet. Die Oberkante bildet als Tangenzialwinkel den Gangwinkel α aus, der die Steilheit der Steigung der Helix bestimmt.

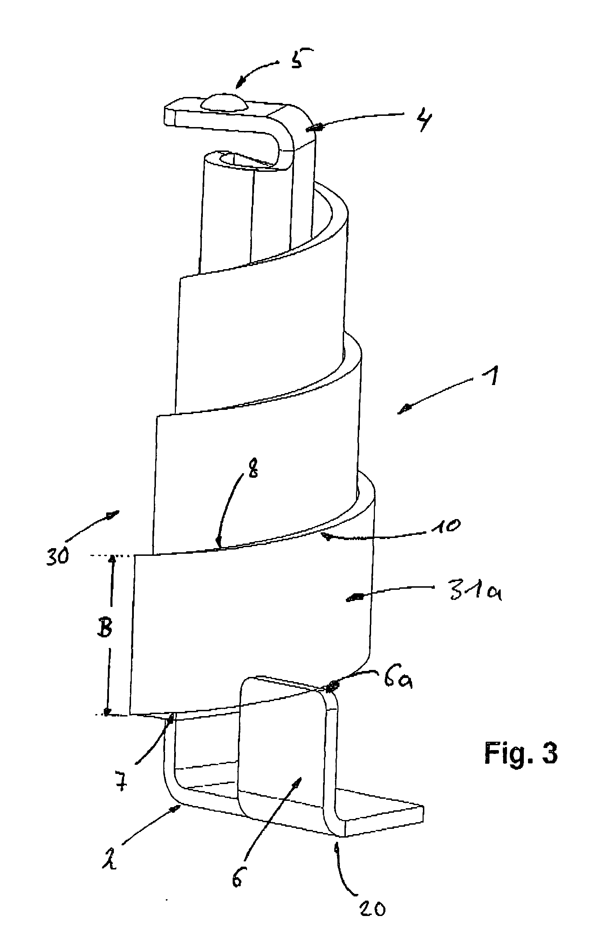

Wie in Fig. 3 deutlich ersichtlich, ist am Anschlussabschnitt 2 ein Stützabschnitt 6 zum Abstützen der untersten Spiralwendel 31a an deren Unterkante 7 angeordnet.

Bei Betätigen des Kontaktabschnittes 4 durch Eindrücken des Federkontaktes 1 kann somit die jeweils obere Spitalwendel 31b, 31c in die jeweils darunter angeordnete Spiralwendel 31 a, 31 b teilweise bis vollständig eintauchen. Hierbei verhindert der Stützabschnitt 6 mit seiner Stützabschnittfläche 6a ein Wegkippen des Kontaktfederabschnittes 30, der zwingend auftritt, da die helixförmige archimedische Spirale in ihrem Verbindungsabschnitt 12 in folge der Kraftbeaufschlagung ein Drehmoment erfährt.

Durch die erfindungsgemäße Ausbildung wird verhindert, dass ein unbeabsichtigtes Wegbiegen des Kontaktfederabschnittes 30 und damit ein Verbiegen des Federkontaktes 1 verhindert wird.

Mit Vorteil ist die Breite B der Kontaktzunge 3 im Bereich des Kontaktfederabschnittes 30 verbreitert ausgebildet gegenüber der Ganghöhe H, wodurch ein Überlappbereich 10 zwischen zwei benachbarten Spiralwendeln 31a, 31 b, 31 c ausgebildet wird. Der Überlappbereich 10 folgt kontinuierlich der Spirallinie und gewährleistet, dass die Unterkante 7 einer Spiralwendel 31 b, 31 c nicht auf der Oberkante 8 der jeweils darunter liegenden Spiralwendel 31 a, 31 b aufsitzt.

Alternativ kann dies auch dadurch gewährleistet werden, dass nur Teile oder Teilbereiche eines jeden Spiralwendel 31 a, 31 b, 31c verbreitert gegenüber der Ganghöhe h der helixförmigen archimedischen Spirale ausgebildet ist.

In Fig. 2 sieht man deutlich die archimedische Spirale in der Ebenenprojektion. Diese entspricht einem aufgewickelten Teppich der Dicke D, wobei die Innenseite einer jeden Spiralwendel 31 a, 31 b, 31 c an die Außenseite der dazu benachbarten Spiralwendel 31a, 31b, 31c anliegt.

Mit Vorteil liegt zwischen zwei benachbarten Spiralwendeln 31a, 31 b, 31 c ein Spalt 11, so dass Haft- und Gleitreibungseffekte zwischen den einzelnen Spiralwendeln verhindert oder minimiert werden.

Wie in Fig. 3 deutlich ersichtlich, weist der Anschlussabschnitt 2 eine im wesentliche ebene Unterseite auf, die zur Kontaktierung der Leiterplatte als Lötanschluss ausgebildet ist. Von dieser kragt im einfachsten Fall der Stützabschnitt 6 im wesentlichen im 90° gebogene L-förmige Auskragung am Anschlussabschnitt 2 aus. Die Oberkante und damit Stützabschnittsfläche 6a des Stützabschnittes 6 kann dabei wahlweise unmittelbar an der Unterkante 7 des Spiralwendels 31a anliegen oder mittels eines kleinen Spaltes von dieser Unterkante 7 beabstandet sein.

Der obere Kontaktabschnitt 4 weist eine im wesentlichen kugelförmige Kontaktkuppe 5 auf. Allgemein kann auch eine andere Form der Kontaktkuppe verwendet werden.

Mit Vorteil ist die Kontaktkuppe 5 galvanisch versilbert oder vergoldet bzw. galvanisch veredelt, um die Leitfähigkeitseigenschaften des Kontaktes zu verbessern.

Die Kontaktkuppe 5 ist mit Vorteil partiell beschichtet Der Federkontakt 1 ist mit Vorteil aus einem anderen gegenüber der Kontaktkuppe 5 unterschiedlichem Material beschichtet oder mittels einer davon unterschiedlichen Oberfläche versehen. Im einfachsten Fall wird allerdings lediglich die Kontaktkuppe 5 des Kontaktabschnittes 4 beschichtet.

In Fig. 4 ist eine Ausführungsform des Federkontaktes an einem sogenannten Pilotstreifen 13 gezeigt. Hierdurch wird es ermöglicht, eine Vielzahl der Federkontakte 1 in einem zueinander definierten Abstand an einem Pilotstreifen 13 befestigt, unmittelbar als Stanz-Biegeteile aus einem gemeinsamen Band, vorzugsweise Federband, herzustellen. Der mittels Löcher 14 gelochte Pilotstreifen erlaubt damit eine serienmäßige Verarbeitung des Federkontaktes 1.

Die helixförmig gewendelte archimedische Spirale kann dabei, wie in Fig. 1 bis Fig. 4 gezeigt, in Achsrichtung, von unten nach oben beginnend, sich nach innen einwendeln oder aber auch gegenüber den Darstellungen spiegelverkehrt angeordnet sein. Dadurch lässt sich je nach Bauraum die unterste Spiralwendel 31a als innen liegende und damit kleinste oder außen liegende und größte Spiralwendel ausbilden.

### Bezugszeichenliste

Federkontakt
- 1: Federkontakt
- 2: Anschlussabschnitt
- 3: Kontaktzunge
- 4: Kontaktabschnitt
- 5: Kontaktkuppe
- 6: Stützabschnitt
- 6a: Stützabschnittsfläche
- 7: Unterkante
- 8: Oberkante

- 10: Überlappbereich
- 11: Spalt
- 12: Verbindungsabschnitt
- 13: Pilotstreifen
- 14: Loch

- 20: Lötfläche

- 30: Kontaktfederabschnitt
- 31a, 31b, 31c: Spiralwendel

## Patentansprüche

1. Federkontakt (1) zur Leiterplattenkontaktierung umfassend einen Anschlussabschnitt (2) sowie einen Kontaktabschnitt (4) zur Kontaktierung mit einem Gegenkontakt, wobei zwischen dem Anschlussabschnitt (2) und dem Kontaktabschnitt (4) ein Kontaktfederabschnitt (30) aus einer Kontaktzunge (3) ausgebildet ist und die Kontaktzunge (3) über eine Kontaktzungenbreite B verfügt, die durch den Abstand zwischen der Unterkante (7) und der Oberkante (8) der Kontaktzunge (3) definiert ist, **dadurch gekennzeichnet, dass** die Kontaktzunge (3) als eine helixförmige archimedische Spirale mit einer Ganghöhe h ausgebildet ist.

2. Federkontakt (1) gemäß Anspruch 1, **dadurch gekennzeichnet, dass** die holixförmige archimedische Spirale wenigstens zwei vollständig ausgebildete Spiralwendel (31 a, 31b, 31c) mit einer Spiralumdrehung von 360° aufweist.

3. Federkontakt (1) gemäß Anspruch 2, **dadurch gekennzeichnet, dass** jede Spiralwendel (31a, 31b, 31c) Ober mindestens einen Teilabschnitt mit einer Breite B verfügt, der größer ist als die Ganghöhe h, derart, dass die jeweils benachbarten Spiralwendel dadurch einen Überlappbereich (10) in Achsrichtung der Spirale aufweisen.

4. Federkontakt (1) gemäß einem der vorhergehenden Ansprüche, **dadurch gekennzeichnet, dass** die helixförmige archimedische Spirale von ihrem, dem Anschlussabschnitt (2) beginnenden unteren Ende, zu dem anderen Ende der Spirale hin in ihrem Radius abnimmt.

5. Federkontakt (1) gemäß Anspruch 1 bis 3, **dadurch gekennzeichnet, dass** die helixförmige archimedische Spirale von ihrem, dem Anschlussabschnitt (2) beginnende Ende, zu dem anderen Ende hin im Radius zunimmt.

6. Federkontakt (1) gemäß einem der vorhergehenden Ansprüche, **dadurch gekennzeichnet, dass** am Anschlussabschnitt (2) ein Stützabschnitt (6) mit einer Stützabschnittsfläche (6a) zum Abstützen der Unterkante (7) eines ersten, dem Anschlussende (2) nahe gelegenem Ende, der Kontaktzunge (3) ausgebildet ist.

7. Federkontakt (1) gemäß Anspruch 6, **dadurch gekennzeichnet, dass** der Stützabschnitt (6) als eine L-förmige Auskragung am Anschlussabschnitt (2) angeformt ist.

8. Federkontakt (1) gemäß einem der vorhergehenden Ansprüche, **dadurch gekennzeichnet, dass** der Anschlussabschnitt (2) eine im wesentlichen flache Lötfläche (20) für eine Leiterplatte aufweist.

9. Federkontakt (1) gemäß einem der vorhergehenden Ansprüche, **dadurch gekennzeichnet, dass** der Kontaktabschnitt (4) als ein in die Ebene des Anschlussabschnittes (2) umgebogene Biegeabschnitt mit einer Kontaktkuppe (5) an dessen Kontaktseite ausgebildet ist.

10. Federkontakt (1) gemäß Anspruch 1, **dadurch gekennzeichnet, dass** die vom Anschlussabschnitt (2) und der Lötfläche (20) gebildete, sowie die vom Kontaktabschnitt (4) gebildete Ebenen eine orthogonale Projektionsebene der Spiralachse bilden.

11. Federkontakt (1) gemäß Anspruch 9, **dadurch gekennzeichnet, dass** die Kontaktkuppe (5) eine galvanische Oberflächenbeschichtung aufweist.
